# FASCICULE DE BREVET EUROPEEN

(11) **EP 2 769 001 B1**
(45) Date de publication et mention de la délivrance du brevet: **20.12.2017**
(21) Numéro de dépôt: 12790607.1
(22) Date de dépôt: 18.10.2012
(51) Int. Cl.: C23C 14/24, C23C 14/26, C23C 14/22

(54) **SYSTEME D'INJECTION POUR DISPOSITIF DE DEPOT DE COUCHES MINCES PAR EVAPORATION SOUS VIDE**
EINSPRITZSYSTEM FÜR EINE VORRICHTUNG ZUR ABSCHEIDUNG DÜNNER SCHICHTEN MITTELS VAKUUMVERDAMPFUNG
INJECTION SYSTEM FOR AN APPARATUS FOR DEPOSITING THIN LAYERS BY VACUUM EVAPORATION

(30) Priorité: 21.10.2011 FR 1159560
(43) Date de publication de la demande: 27.08.2014
(73) Titulaire: Riber, 95870 Bezons (FR)
(72) Inventeur: GUYAUX, Jean-Louis, 91380 Chilly Mazarin (FR); VILLETTE, Jérôme, 92350 Le Plessy Robinson (FR); BRIANT, Nicolas, 77680 Roissy en Brie (FR); ESTEVE, David, 78380 Bougival (FR)
(74) Mandataire: Jacobacci Coralis Harle
(86) Numéro de dépôt international: PCT/FR2012/052388
(87) Numéro de publication internationale: WO 2013/057443

(56) Documents cités:
- DE-A1-102010 046 389
- US-A1- 2006 127 599
- US-A1- 2011 027 462

## Description

La présente invention concerne un système d'injection pour dispositif de dépôt par évaporation sous vide, encore appelé PVD pour Physical Vapor Deposition.

On connaît des dispositifs de dépôt sous vide de matériaux évaporés à partir d'une source de matériau solide. De tels dispositifs sont notamment utilisés dans la fabrication d'empilements de couches minces sur des substrats de grande taille. Par exemple de tels dispositifs sont utilisés pour la fabrication de panneaux solaires de type CIGS (pour Cuivre Indium Gallium Sélénium) ou de diodes de type OLED (pour Organic Light Emitting Devices). Les dispositifs de dépôt sous vide par PVD comprennent généralement une source d'évaporation reliée à une chambre de dépôt sous vide. La source d'évaporation permet d'évaporer ou de sublimer le matériau, qui est transféré sous forme gazeuse dans la chambre de dépôt sous vide où il est déposé sur un substrat.

Les dispositifs connus de dépôt sous vide comprennent généralement un injecteur placé entre la source d'évaporation et le substrat. L'injecteur permet de diffuser le matériau évaporé afin d'obtenir un dépôt uniforme sur un substrat de grande taille. La géométrie de l'injecteur dépend de la forme et de la taille du substrat. Pour de grands substrats rectangulaires, on utilise un injecteur formé d'un conduit de forme allongée comprenant des ouvertures, encore appelées buses d'injection, pour diffuser le matériau évaporé de manière uniforme le long de l'injecteur. La longueur de l'injecteur est au moins égale à la largeur ou la longueur d'un substrat. Un mouvement relatif entre le substrat et l'injecteur permet des dépôts sur de très grandes surfaces (supérieures à 1 m²).

On connaît aussi un injecteur muni de buses d'injection disposées le long de l'injecteur. Chaque buse comprend généralement un canal reliant le conduit interne de l'injecteur à la chambre de dépôt sous vide. La forme et les dimensions des buses permettent d'adapter le débit et la distribution du flux de matériau évaporé sur la surface du substrat.

Une chambre d'évaporation sous vide peut être configurée pour permettre le dépôt sur un unique substrat ou sur plusieurs substrats placés dans une même chambre de dépôt. Toutefois, le changement de taille de substrats ou du nombre de substrats à traiter nécessite en général un changement d'injecteur de manière à s'adapter à la configuration du substrat et éviter les pertes de matériau par dépôt dans la chambre de dépôt sous vide en dehors des substrats.

Dans ce cas, il est nécessaire de disposer de plusieurs injecteurs adaptés chacun à une configuration particulière. On dispose ainsi par exemple d'autant d'injecteurs qu'il existe de largeur de substrats. Or chaque injecteur est coûteux. De plus, il est nécessaire de procéder à un nettoyage régulier de l'injecteur pour éviter l'accumulation de dépôts internes dans l'injecteur et/ou dans les buses. Cette opération de nettoyage nécessite un arrêt de la machine de dépôt sous vide, dont la durée doit être aussi courte que possible.

Un des buts de l'invention est d'assurer une bonne qualité de dépôt de couches minces par PVD, y compris d'uniformité d'épaisseur et de composition physico-chimique des couches pour des largeurs de 1,5 à 1,8 m.

Il est souhaitable de pouvoir adapter plus facilement la configuration d'une chambre de dépôt par évaporation sous vide afin d'accepter des substrats de taille différente, sans augmenter le coût du dispositif.

Il est également souhaitable de minimiser la durée d'arrêt d'une chambre d'évaporation sous vide pour améliorer le rendement du dispositif d'évaporation.

La présente invention a pour but de remédier aux inconvénients des techniques antérieures et concerne plus particulièrement un système d'injection pour dispositif de dépôt de couches minces par évaporation sous vide, ledit système d'injection étant destiné à être placé dans une chambre d'évaporation sous vide, et ledit système d'injection comprenant un réservoir destiné à recevoir un matériau à évaporer, des moyens de chauffage du réservoir aptes à évaporer ledit matériau, au moins une rampe d'injection comprenant un conduit interne relié au réservoir de manière à recevoir ledit matériau évaporé provenant du réservoir et une pluralité de buses, chaque buse comprenant au moins un canal de communication entre ledit conduit interne et la partie extérieure de la rampe de manière à diffuser le matériau évaporé dans ladite chambre d'évaporation sous vide.

Selon l'invention, la rampe d'injection comprend une pluralité de modules d'injection reliés mécaniquement entre eux en série le long d'une direction longitudinale, chaque module d'injection comprenant une pluralité de buses d'injection, et ladite rampe d'injection comprend des moyens de réglage en orientation desdits modules d'injection autour de ladite direction longitudinale de manière à aligner lesdites buses d'injection desdits modules d'injection le long d'une ligne parallèle à la direction longitudinale de la rampe d'injection.

Selon un mode de réalisation particulier de l'invention, lesdits modules d'injection sont de forme cylindrique, les buses d'injection d'un module d'injection étant disposées sur une génératrice dudit cylindre.

Selon différents aspects de l'invention :
- lesdits modules d'injection ont une structure identique, la rampe d'injection comprenant en outre un module obturateur apte à fermer une extrémité de la rampe d'injection de manière étanche ;
- ledit réservoir est formé d'au moins un premier module réservoir cylindrique apte à être fixé sur un premier module d'injection à une première extrémité ouverte de la rampe d'injection et/ou d'un second module réservoir cylindrique apte à être fixé sur un dernier module d'injection à une deuxième extrémité ouverte de la rampe d'injection ;
- le matériau des modules d'injection est l'un des matériaux suivants : de l'alumine (Al₂O₃), du carbone graphite, du carbone vitreux, du carbone revêtu graphite pyrolytique, du carbone purifié, du carbone revêtu de carbure de silicium ou du nitrure de bore pyrolytique (ou PBN).

Selon différents aspects de modes de réalisation de l'invention, le système d'injection comprend en outre :
- au moins un joint d'étanchéité par compression, ledit joint d'étanchéité étant apte à assurer l'alignement des buses lorsqu'il est comprimé ;
- ledit au moins un joint d'étanchéité étant en graphite souple ;
- ledit au moins un joint d'étanchéité étant disposé entre deux modules d'injection adjacents et/ou entre le module réservoir et le premier module d'injection et/ou entre le dernier module d'injection et un module obturateur ;
- des moyens de chauffage indépendants associés à chaque module d'injection et/ou au module réservoir, lesdits moyens de chauffage comprenant deux demi-coquilles semi-cylindriques aptes à envelopper ledit module d'injection respectivement ledit module réservoir;
- des moyens d'écrantage thermique disposés autour des moyens de chauffage et des moyens de refroidissement disposés autour des moyens d'écrantage thermique ;
- un châssis et des moyens mécaniques de fixation de la pluralité de modules d'injection et/ou du module réservoir sur ledit châssis ;
- ledit châssis comprend une ou plusieurs barres rectilignes, lesdits moyens de fixation étant montés de manière à pouvoir coulisser le long de la ou desdites barres.

L'invention concerne aussi un système d'injection comprenant une pluralité de rampes d'injection selon l'un des modes de réalisation décrits, les axes longitudinaux desdites rampes d'injection étant disposés parallèlement entre eux pour permettre une co-évaporation uniforme de matériaux.

L'invention trouvera une application particulièrement avantageuse dans un dispositif d'injection pour système de dépôt par évaporation sous vide, notamment pour la fabrication des OLED.

La présente invention concerne également les caractéristiques qui ressortiront au cours de la description qui va suivre et qui devront être considérées isolément ou selon toutes leurs combinaisons techniquement possibles.

Cette description donnée à titre d'exemple non limitatif fera mieux comprendre comment l'invention peut être réalisée en référence aux dessins annexés sur lesquels :
- la figure 1 représente une rampe d'injection, en vue de face et en coupe longitudinale selon un premier mode de réalisation de l'invention ;
- la figure 2 représente une rampe d'injection, en vue de dessous et en coupe longitudinale selon un second mode de réalisation de l'invention ;
- la figure 3 représente une rampe d'injection, en vue de face, de côté, en coupe axiale et en coupe longitudinale ;
- la figure 4 représente une vue de face et en perspective d'une coquille thermique destinée à envelopper un module d'une rampe d'injection selon un mode de réalisation particulier de l'invention ;
- la figure 5 représente schématiquement une vue en perspective d'une rampe d'injection lors du montage /démontage d'un réservoir selon un mode de réalisation particulier ;
- la figure 6 représente schématiquement une vue en perspective d'une rampe d'injection lors du montage /démontage d'un réservoir selon un autre mode de réalisation particulier ;
- la figure 7 représente schématiquement en vue de côté différentes configurations de dépôt basées sur l'utilisation respectivement d'une rampe d'injection unique pour la mono-évaporation et de deux et trois rampes d'injection pour la co-évaporation.

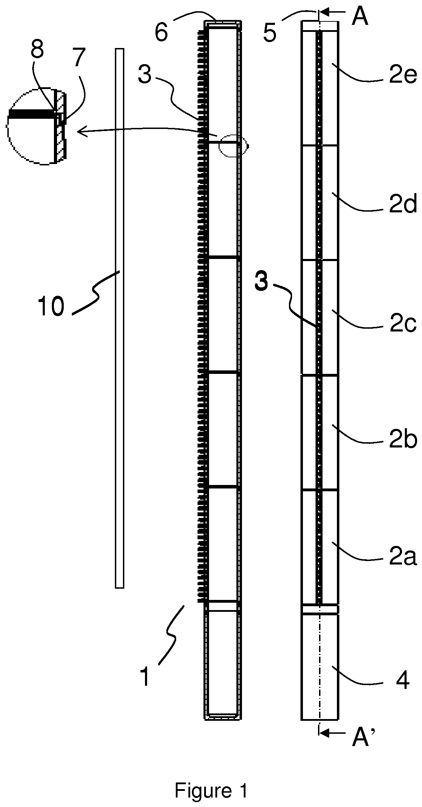

L'invention concerne une rampe d'injection pour un système de dépôt par évaporation sous vide, la rampe d'injection étant apte à recevoir des matériaux vaporisés d'une source d'évaporation. De manière connue en soi, une rampe comprend un diffuseur muni d'une pluralité de buses pour diffuser le matériau vaporisé dans une chambre de dépôt sous vide. La chambre d'évaporation dans laquelle se trouvent le substrat et la rampe d'injection n'est pas représentée sur les figures 1 à 6.

La figure 1 représente schématiquement une rampe d'injection selon un premier mode de réalisation de l'invention. La partie droite de la figure 1 représente une vue de face d'une rampe d'injection 1. Sur la partie gauche de la figure 1, on a représenté un substrat 10 sur lequel on souhaite déposer un matériau et la rampe d'injection 1 en coupe longitudinale suivant la direction AA'. En insert, sur la partie gauche de la figure 1 est représenté un agrandissement d'un détail de la vue en coupe de la rampe.

Nous allons tout d'abord détailler la vue de face de la rampe d'injection de la figure 1. La rampe d'injection s'étend selon un axe longitudinal 5. La rampe d'injection 1 comprend un module réservoir 4 destiné à contenir le matériau à évaporer. Le matériau à évaporer peut se présenter sous différentes formes (liquide, solide, poudre...). En particulier, le réservoir est destiné à évaporer les matériaux suivants : argent (Ag), magnésium (Mg), gallium (Ga), indium (In), fluorure de lithium (LiF), sulfure d'indium (In₂S₃), zinc (Zn), cadmium (Cd), étain (Sn), aluminium (Al) ou cuivre (Cu). Selon le mode de réalisation de la figure 1, la rampe d'injection 1 est principalement destinée à être montée verticalement. Dans ce cas, le module réservoir 4 est positionné au niveau de l'extrémité inférieure de la rampe de manière à contenir le matériau non évaporé par gravité. Dans l'exemple représenté sur la figure 1, le module réservoir est dans l'alignement de la rampe. Toutefois, le module réservoir 4 peut avoir une géométrie, une disposition (en ligne, à 45°, à 90° par rapport à l'axe longitudinal 5) ou encore une capacité (longueur, diamètre) bien particulière suivant le fonctionnement (horizontal ou vertical), le matériau à évaporer, la durée de production du système d'injection ou encore la consommation de matériau à évaporer.

La rampe d'injection 1 comporte aussi plusieurs modules d'injection 2a, 2b, 2c, 2d, 2e montés en série. L'exemple représenté comporte cinq modules d'injection. Toutefois, le nombre de modules d'injection n'est bien sûr pas limité. Le premier module d'injection 2a est fixé sur le module réservoir 4. Le module d'injection 2b est fixé sur un module d'injection 2a. De même, le module d'injection 2c est fixé sur un module d'injection 2b, etc... Enfin, un module obturateur 6 est fixé sur le module d'injection 2e. L'extrémité de la rampe 1 opposée au module réservoir 4 est ainsi fermée par le module obturateur 6 étanche à la vapeur dudit matériau à évaporer. Le module obturateur 6 peut être intégré à un module d'injection d'extrémité pour ne former qu'un seul module d'injection fermé à une extrémité. Les différents modules d'injection composant la rampe peuvent être fixés l'un à l'autre, par exemple par emboîtement ou par vissage. Les modules d'injection sont orientables autour de leur axe de façon à pouvoir effectuer un réglage angulaire de chaque module d'injection. Ce réglage en orientation permet d'assurer l'alignement des buses le long de la rampe, cet alignement étant critique pour la qualité des dépôts. Dans le cas où les modules d'injection sont vissés l'un à l'autre, chaque module d'injection comporte un filetage 7 adapté. Lors de l'usinage d'un module, la position de départ du filet est contrôlée par rapport à la position des buses, ce qui donne un alignement grossier, l'alignement fin est assuré par la compression d'un joint d'étanchéité. De préférence, on dispose un joint d'étanchéité 8 entre deux modules d'injection. Le joint assure l'étanchéité de la fixation vis-à-vis de la chambre d'évaporation sous vide tout en permettant le réglage en orientation des modules d'injection.

Comme on peut l'observer sur la vue en coupe de la figure 1, le module réservoir 4 et les modules d'injection 2a, 2b, 2c, 2d, 2e sont de forme tubulaire et creuse. Les modules d'injection sont cylindriques, les buses étant alignées sur une génératrice du cylindre. Selon un mode de réalisation préféré, les modules d'injection sont de section à peu près circulaire mais comportent un méplat qui porte les buses.

Le module d'injection 2a communique avec le réservoir 4 par une ouverture centrale. Le module d'injection 2b communique également avec le module d'injection 2a par une ouverture centrale et ainsi de suite jusqu'au module d'injection 2e et au module obturateur 6. Le matériau évaporé sortant du réservoir peut ainsi diffuser librement a l'intérieur de tous les modules de la rampe d'injection jusqu'au module obturateur. Le diamètre intérieur des différents module de la rampe d'injection est suffisant pour que sa conductance assure une perte de charge faible ou négligeable, assurant par la même un flux identique sur chaque buse.

Chaque module d'injection 2a, 2b, ... 2e est muni d'une pluralité de buses d'injection 3. Une buse 3 comprend généralement un canal reliant l'intérieur de la rampe à la chambre d'évaporation pour permettre la diffusion du matériau évaporé vers le substrat 10. De préférence, les buses 3 des différents modules sont alignées suivant un axe parallèle à l'axe 5 de la rampe. Selon un exemple de réalisation, chaque module d'injection 2 comporte une vingtaine de buses 3. Selon l'invention, les buses sont réparties avec un intervalle constant entre buses consécutives de manière à obtenir une distribution spatialement uniforme des buses 3 le long d'un axe parallèle à l'axe 5. Selon un mode de réalisation préféré, chaque buse est constituée par un élément rapporté, par exemple vissé sur le module d'injection. Dans ce cas, une buse est interchangeable avec une buse ayant une ouverture différente. On peut ainsi disposer des buses 3 ayant des ouvertures différentes selon la position de la buse 3 le long de la rampe 1, afin d'ajuster le profil de dépôt sur toute la surface du substrat 10. Selon un exemple de réalisation, la longueur d'un module d'injection 2a est égale à 400mm, la précision d'orientation par rotation autour de l'axe longitudinal étant inférieure à deux degrés, l'espace entre buses est égal à 20mm, et le filetage 7 s'étend sur 10mm de long.

De préférence, les modules d'injection, le module obturateur et/ou le module réservoir sont fabriqués dans un matériau qui présente une compatibilité chimique avec le matériau à évaporer à la température d'évaporation souhaitée. Par exemple, le matériau des modules d'injection du module réservoir et/ou d'un module obturateur peut être du carbone, du graphite, du graphite pyrolytique, du carbone vitreux, du nitrure de bore, de l'alumine... Une rondelle d'étanchéité 8 en graphite souple de l'ordre de 1 mm d'épaisseur est intercalée entre deux modules adjacents pour assurer l'étanchéité et aussi pour permettre d'ajuster l'orientation des différents modules d'injection 2a, 2b... et permettre ainsi d'aligner les buses 3.

Comme détaillé ci-dessus, la rampe 1 est donc constituée de différents modules reliés en série pour former une cellule linéaire le long de l'axe 5 : module réservoir, modules d'injection et module obturateur. Le nombre de modules d'injection détermine la longueur de la rampe et est facilement reconfigurable.

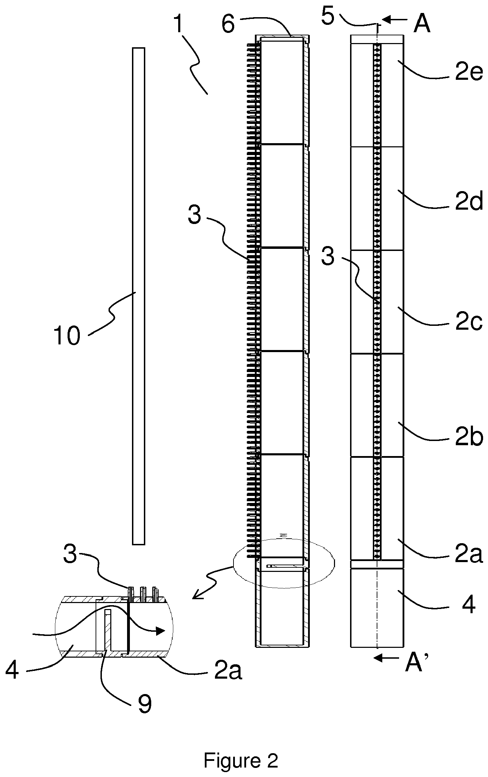

La figure 2 représente un second mode de réalisation de rampe d'injection, destinée plus particulièrement à être montée horizontalement suivant l'axe 5. La partie droite de la figure 2 représente une vue de dessous d'une rampe d'injection 1. Sur la partie gauche de la figure 2, on a représenté un substrat 10 sur lequel on souhaite déposer un matériau et la rampe d'injection 1 en coupe longitudinale suivant une coupe AA'. En insert est représenté un agrandissement d'un détail de la vue en coupe de la rampe. Les mêmes signes de référence désignent les mêmes éléments que sur la figure 1. La rampe de la figure 2 comporte également un module réservoir 4, plusieurs modules d'injection 2a, 2b, 2c, 2d, 2e montés en série et munis de buses d'injection 3, et un module obturateur 6. En insert est représentée une vue en coupe d'un module intermédiaire situé entre le module réservoir 4 et le premier module d'injection 2a. Le module intermédiaire est fixé d'une part à l'ouverture du réservoir et d'autre part au premier module d'injection 2a. Le module intermédiaire 9 comporte une paroi interne qui obture partiellement l'ouverture interne de la rampe de manière à contenir le matériau non évaporé dans le réservoir. La paroi interne comporte une ouverture destinée à laisser passer le flux de matériau évaporé (représenté schématiquement par une flèche sur l'insert de la figure 2). Ce module intermédiaire 9 avec paroi interne est particulièrement adapté dans le cas où le module réservoir est aligné horizontalement pour permettre de maintenir le matériau non évaporé dans le module réservoir 4. Le module intermédiaire est orientable par rotation autour de l'axe 5 de la rampe, de manière à ce que l'ouverture de la paroi interne se situe dans la partie supérieure de la rampe, comme représenté en insert, dans le cas où les buses sont orientées vers le haut.

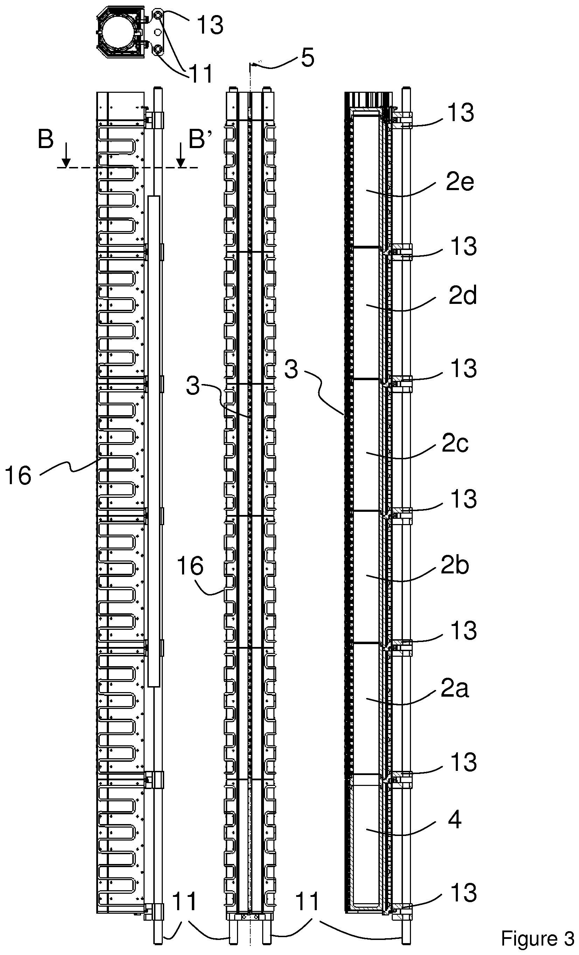

La figure 3 représente différentes vues d'une rampe d'injection munie de moyens de chauffage pour permettre l'évaporation et la diffusion de matériau. Au centre de la figure 3 est représentée une rampe en vue de face, à gauche de la figure 3 en vue de côté, à droite de la figure 3 une vue en coupe longitudinale suivant l'axe 5 et en haut à gauche de la figure 3 une vue en coupe axiale de la rampe suivant le plan de coupe BB'. La rampe comprend les différents modules tels que décrits en lien avec la figure 1, notamment un module réservoir 4, plusieurs modules d'injection 2a,..., 2e et un module d'extrémité 6. Le module réservoir 4 ainsi que chaque module d'injection est enveloppé par une coquille thermique. Chaque coquille thermique a la même longueur que le module réservoir ou module d'injection qu'elle enveloppe. On observe sur les vues de face et de côté, des moyens de refroidissement externes des coquilles thermiques, sous la forme de serpentins 16 destinés à la circulation d'un fluide de refroidissement, par exemple de l'eau. La rampe d'injection est montée sur un châssis comprenant deux barres 11 cylindriques, les barres 11 étant parallèles entre elles et parallèles à l'axe 5 de la rampe. La rampe 1 est fixée sur le châssis au moyen de pattes de fixation 13. Avantageusement les pattes de fixation 13 sont réglables par glissement le long de l'axe des barres 11.

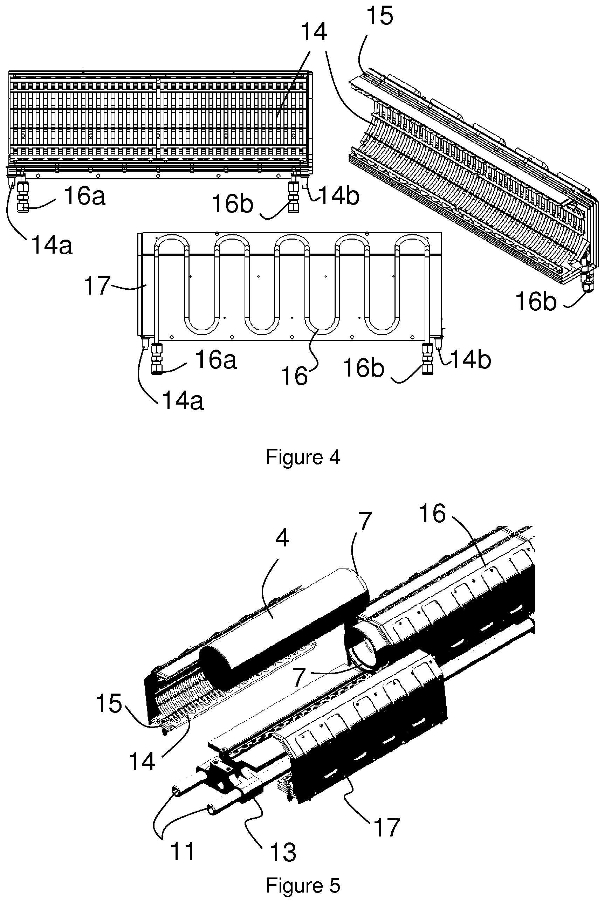

De manière préférée, une coquille thermique est composée de deux demi-coquilles de forme générale semi-cylindrique et destinées à envelopper une rampe de forme extérieure également cylindrique. Les deux demi-coquilles formant une coquille thermique sont symétriques par rapport à un plan passant par l'axe longitudinal 5 de la rampe. La figure 4 représente une vue en face avant, en face arrière et en perspective d'une demi-coquille thermique destinée à envelopper un module d'une rampe d'injection selon un mode de réalisation particulier. La demi-coquille 17 comprend sur sa face intérieure un filament 14 destiné à chauffer un module de la rampe par rayonnement. Le filament 14 permet de porter la rampe d'injection à une température pouvant atteindre 1200° C à 1500° C. La demi-coquille 17 comporte des raccords électriques 14a, 14b aux deux extrémités du filament 14. Chaque demi-coquille thermique peut ainsi être reliée à une source de courant électrique indépendamment des autres coquilles thermiques. Chaque demi-coquille thermique peut également être reliée en série avec les autres coquilles thermiques à une source de courant électrique unique. Le filament est protégé vis-à-vis de l'environnement de la rampe par un écran thermique 15. Un système de refroidissement 16 à eau placé sur la partie extérieure de la coquille 17 permet de réduire la température extérieure de la rampe. Le système de refroidissement 16 comporte des raccords fluidiques 16a, 16b aux deux extrémités du circuit de refroidissement d'une demi-coquille. Chaque demi-coquille thermique peut ainsi être reliée à une source d'eau de refroidissement indépendamment des autres demi-coquilles thermiques. Chaque demi-coquille thermique peut également être reliée en série aux autres demi-coquilles thermiques à une source d'eau de refroidissement unique.

Il est nécessaire de procéder au remplissage du module réservoir une fois le matériau consommé. Il peut être nécessaire de procéder au remplacement du réservoir dans une opération de maintenance. La figure 5 représente schématiquement une vue en perspective d'une rampe d'injection lors du montage/démontage d'un réservoir selon un mode de réalisation particulier. Dans ce mode de réalisation, on détache les deux demi-coquilles thermiques 17 qui enveloppent le module réservoir. On accède ainsi au module réservoir 4. Le module réservoir est emboîté ou vissé par des filetages 7 sur le premier module d'injection 2a. Ce système permet de laisser la rampe d'injection en place dans la chambre d'évaporation. De plus, le changement de réservoir peut être fait très rapidement.

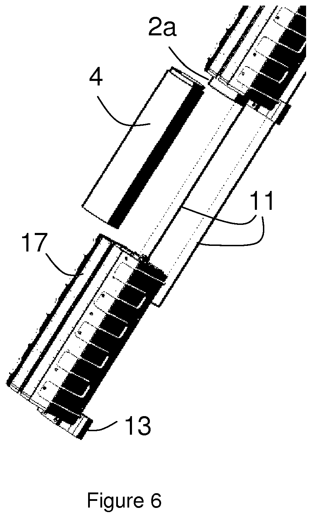

La figure 6 représente schématiquement une vue en perspective d'une rampe d'injection lors du montage /démontage d'un réservoir selon un autre mode de réalisation particulier. Dans ce cas, la coquille thermique enveloppant le module réservoir n'est pas démontée, mais simplement déplacée en desserrant la patte fixation 13 puis en faisant glisser la coquille thermique le long des barres 11 du châssis. L'espace libéré permet d'accéder au réservoir, pour le remplir ou le remplacer. Au remontage, il suffit de fixer le module réservoir 4 sur le premier module d'injection 2a, puis de faire glisser la coquille 17 le long des barres 11 de manière à ce qu'elle enveloppe le module réservoir 4. Les pattes de fixation peuvent être maintenues par des vis.

Il est également envisageable de procéder au remplissage du réservoir sans démonter le module réservoir ni la coquille thermique. Par exemple, il est possible de démonter uniquement un module d'extrémité 6, sans avoir à démonter de coquille thermique. Il est alors possible de procéder au remplissage du réservoir à l'autre extrémité de la rampe d'injection, par des moyens appropriés, tels un bec verseur ou encore un « pipe line de chargement ». Une solution alternative consiste à glisser un container ouvert (communément appelé « boat ») dans la rampe d'injection depuis l'extrémité opposée au module réservoir. Cette dernière configuration semble plus en adéquation avec un fonctionnement horizontal de la rampe. Ce container contient le matériau à évaporer.

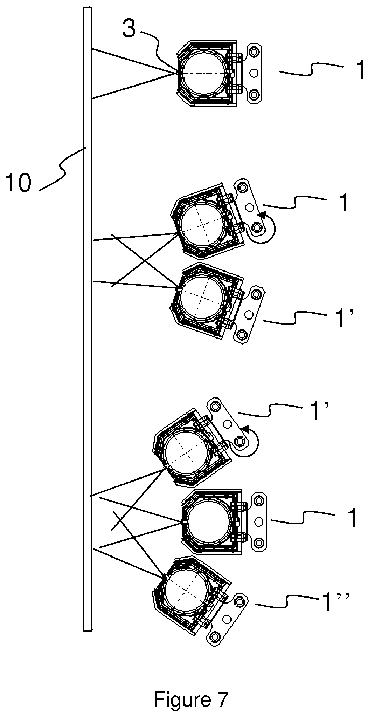

Le châssis assure la rigidité de l'ensemble de la rampe d'injection 1. De plus, le châssis permet d'interfacer la rampe d'injection avec un système de transfert pour produire un mouvement de la rampe par rapport à des substrats de grande taille. Enfin, le châssis permet facilement d'orienter une ou plusieurs rampes d'injection par rapport au plan d'un substrat. Ainsi, la figure 7 illustre différentes configurations de dépôt. En haut de la figure 7 on a illustré l'utilisation d'une rampe d'injection unique pour la mono-évaporation à partir d'un réservoir de matériau. Au centre de la figure 7 est représentée un système à deux rampes d'injection 1 et 1'. Chacune des deux rampes d'injection 1, 1' comporte son propre réservoir de matériau. Ce système à deux rampes d'injection permet facilement la co-évaporation de matériaux différents, qui se déposent au même moment sur le substrat. Les barres 11 de chaque rampe permettent par simple rotation autour d'une barre d'orienter chaque rampe par exemple de manière symétrique par rapport à la normale au substrat. Les deux rampes ont avantageusement la même longueur, sont parallèles entre elles, et parallèles au plan du substrat ce qui permet d'obtenir une co-évaporation homogène sur toute la longueur des rampes 1 et 1'. De manière analogue, un système à trois rampes d'injection 1, 1', 1" est représenté en bas de la figure 7. Chacune des trois rampes d'injection 1, 1', 1" comporte son propre réservoir de matériau, pour permettre la co-évaporation de trois matériaux différents, déposés simultanément sur le substrat 10. Avantageusement, les trois rampes ont la même longueur, sont disposées parallèlement entre elles et parallèlement au plan du substrat 10, pour permettre une co-évaporation uniforme.

La construction de la rampe d'injection par assemblage de différents modules (modules d'injection, module réservoir) permet de s'adapter aisément à la taille du substrat à traiter et notamment aux grandes tailles de substrat. La fabrication d'une rampe de longueur particulière repose sur l'assemblage d'un nombre prédéterminé de modules d'injection, mais ne nécessite pas d'étude ni d'outillage spécifique et est donc d'un moindre coût. D'autre part, le module réservoir est facile à charger et à décharger, ce qui permet de réduire le temps où l'appareil est arrêté et donc d'améliorer le rendement de la machine d'évaporation sous vide. La construction linéaire de la rampe d'injection permet d'envisager des configurations de co-évaporation uniforme à deux ou trois rampes d'injection, voire plus.

## Revendications

1. Système d'injection pour dispositif de dépôt de couches minces sur un substrat (10) par évaporation sous vide, ledit système d'injection étant destiné à être placé dans une chambre d'évaporation sous vide, et ledit système d'injection comprenant :
▪ un réservoir (4) destiné à recevoir un matériau à évaporer,
▪ des moyens de chauffage du réservoir aptes à évaporer ledit matériau,
▪ au moins une rampe d'injection (1) comprenant un conduit interne relié au réservoir (4) de manière à recevoir ledit matériau évaporé provenant du réservoir (4) et une pluralité de buses (3), chaque buse (3) comprenant au moins un canal de communication entre ledit conduit interne et la partie extérieure de la rampe de manière à diffuser le matériau évaporé dans ladite chambre d'évaporation sous vide pour permettre la diffusion du matériau évaporé vers le substrat,
**caractérisé en ce que** :
▪ la rampe d'injection (1) comprend une pluralité de modules d'injection (2a, 2b, 2c, 2d, 2e) reliés mécaniquement entre eux en série le long d'une direction longitudinale (5), chaque module d'injection (2a, 2b, 2c, 2d, 2e) communiquant avec un ou au plus deux modules d'injection adjacents par le conduit interne, le réservoir (4) étant relié mécaniquement à un premier module d'injection (2a) de la pluralité de modules d'injection à une première extrémité de la rampe d'injection, et le premier module d'injection (2a) communiquant avec le réservoir (4) par le conduit interne, chaque module d'injection (2a, 2b, 2c, 2d, 2e) comprenant une pluralité de buses d'injection (3), les buses d'injection (3) étant réparties avec un intervalle constant entre buses consécutives de manière à obtenir une distribution spatialement uniforme des buses d'injection (3) le long d'un axe parallèle à la direction longitudinale (5), et
▪ ladite rampe d'injection (1) comprend des moyens de réglage en orientation desdits modules d'injection (2a, 2b, 2c, 2d, 2e) autour de ladite direction longitudinale (5) de manière à aligner lesdites buses d'injection (3) desdits modules d'injection (2a, 2b, 2c, 2d, 2e) le long d'une ligne parallèle à la direction longitudinale (5) de la rampe d'injection (1) tout en assurant l'étanchéité de la fixation desdits modules d'injection vis-à-vis de la chambre d'évaporation sous vide.

2. Système d'injection selon la revendication 1, dans lequel lesdits modules d'injection (2a, 2b, 2c, 2d, 2e) sont de forme cylindrique, les buses d'injection (3) d'un module d'injection (2a, 2b, 2c, 2d, 2e) étant disposées sur une génératrice dudit cylindre.

3. Système d'injection selon la revendication 2, dans lequel lesdits modules d'injection (2a, 2b, 2c, 2d, 2e) ont une structure identique, la rampe d'injection comprenant en outre un module obturateur (6) apte à fermer une extrémité de la rampe d'injection de manière étanche.

4. Système d'injection selon l'une des revendications 1 à 2, dans lequel ledit réservoir est formé d'au moins un premier module réservoir (4) cylindrique apte à être fixé sur le premier module d'injection à le première extrémité de la rampe d'injection et/ou d'un second module réservoir cylindrique apte à être fixé sur un dernier module d'injection à une deuxième extrémité de la rampe d'injection.

5. Système d'injection selon l'une des revendications 1 à 4 dans lequel le matériau des modules d'injection (2a, 2b, 2c, 2d, 2e) est l'un des matériaux suivants : de l'alumine (Al₂O₃), du carbone graphite, du carbone vitreux, du carbone revêtu graphite pyrolytique, du carbone purifié, du carbone revêtu de carbure de silicium ou du nitrure de bore pyrolytique.

6. Système d'injection selon l'une des revendications 1 à 5 comprenant en outre au moins un joint d'étanchéité par compression disposé entre deux modules d'injection (2a, 2b, 2c, 2d, 2e) adjacents et/ou entre le module réservoir (4) et le premier module d'injection (2a) et/ou entre le dernier module d'injection (2e) et un module obturateur (6), ledit au moins un joint d'étanchéité étant apte à assurer l'alignement des buses lorsqu'il est comprimé.

7. Système d'injection selon l'une des revendications 1 à 6, comprenant en outre des moyens de chauffage (14) indépendants associés à chaque module d'injection et/ou au module réservoir, lesdits moyens de chauffage (14) comprenant deux demi-coquilles semi-cylindriques aptes à envelopper ledit module d'injection (2a, 2b, 2c, 2d, 2e) respectivement ledit module réservoir (4).

8. Système d'injection selon la revendication 7, dans lequel les demi-coquilles comprennent en outre des moyens d'écrantage thermique (15) disposés autour des moyens de chauffage (14) et des moyens de refroidissement (16) disposés autour des moyens d'écrantage thermique (15).

9. Système d'injection selon l'une des revendications 1 à 8 comprenant en outre un châssis (11) et des moyens mécaniques de fixation (13) de la pluralité de modules d'injection (2a, 2b, 2c, 2d, 2e) et/ou du module réservoir (4) sur ledit châssis.

10. Système d'injection selon la revendication 9 dans lequel ledit châssis comprend une ou plusieurs barres (11) rectilignes, lesdits moyens de fixation étant montés de manière à pouvoir coulisser le long de la ou desdites barres (11).

11. Système d'injection selon l'une des revendications 1 à 3 comprenant une pluralité de rampes d'injection, les axes longitudinaux (5) desdites rampes d'injection étant disposés parallèlement entre eux pour permettre une co-évaporation uniforme de matériaux.

## Patentansprüche

1. Einspritzsystem für eine Vorrichtung zur Abscheidung dünner Schichten auf einem Substrat (10) mittels Vakuumverdampfung, wobei das Einspritzsystem dazu bestimmt ist, in einer Vakuumverdampfungskammer angeordnet zu sein, wobei das Einspritzsystem
- einen Tank (4), der dazu bestimmt ist, ein zu verdampfendes Material aufzunehmen,
- Mittel zum Aufheizen des Tanks, die geeignet sind, das besagte Material zu verdampfen,
- wenigstens eine Einspritzleiste (1), die eine mit dem Tank (4) verbundene innere Leitung zur Aufnahme des vom Tank (4) kommenden verdampften Materials und eine Mehrzahl Düsen (3) aufweist, wobei jede Düse (3) wenigstens einen Verbindungskanal zwischen der inneren Leitung und dem äußeren Teil der Leiste aufweist, damit das verdampfte Material in der Vakuumverdampfungskammer verteilt wird, um die Verteilung des verdampften Materials zum Substrat hin zu ermäglichen,
aufweist,
**dadurch gekennzeichnet, daß**
- die Einspritzleiste (1) eine Mehrzahl von Einspritzmodulen (2a, 2b, 2c, 2d, 2e) aufweist, die mechanisch untereinander in Reihe entlang einer Längsrichtung (5) verbunden sind, wobei jedes Einspritzmodul (2a, 2b, 2c, 2d, 2e) über die innere Leitung mit einem oder höchstens zwei angrenzenden Einspritzmodulen in Verbindung ist, wobei der Tank (4) mechanisch mit einem ersten Einspritzmodul (2a) der Mehrzahl von Einspritzmodulen an einem ersten Ende der Einspritzleiste verbunden ist und das erste Einspritzmodul (2a) über die innere Leitung mit dem Tank (4) in Verbindung steht, wobei jedes Einspritzmodul (2a, 2b, 2c, 2d, 2e) eine Mehrzahl von Einspritzdüsen (3) aufweist, wobei die Einspritzdüsen (3) mit einem konstanten Abstand zwischen aufeinanderfolgenden Düsen angeordnet sind, um eine räumlich gleichmäßige Verteilung der Einspritzdüsen (3) entlang einer zur Längsrichtung (5) parallelen Achse zu erhalten, und
- die Einspritzleiste (1) Mittel zum Einstellen der Ausrichtung der Einspritzmodule (2a, 2b, 2c, 2d, 2e) um die Längsrichtung (5) herum aufweist, um die Einspritzdüsen (3) der Einspritzmodule (2a, 2b, 2c, 2d, 2e) entlang einer zur Längsrichtung (5) der Einspritzleiste (1) parallelen Linie auszurichten und gleichzeitig die Dichtigkeit der Befestigung der Einspritzmodule gegenüber der Vakuumverdampfungskammer sicherzustellen.

2. Einspritzsystem gemäß Anspruch 1, **dadurch gekennzeichnet, daß** die Einspritzmodule (2a, 2b, 2c, 2d, 2e) eine zylindrische Form aufweisen, wobei die Einspritzdüsen (5) eines Einspritzmoduls (2a, 2b, 2c, 2d, 2e) auf einer Mantellinie des Zylinders angeordnet sind.

3. Einspritzsystem gemäß Anspruch 2, **dadurch gekennzeichnet, daß** die Einspritzmodule (2a, 2b, 2c, 2d, 2e) eine identische Struktur aufweisen, wobei die Einspritzleiste (1) außerdem ein Verschlußmodul (6) aufweist, das dazu geeignet ist, ein Ende der Einspritzleiste dicht abzuschließen.

4. Einspritzsystem gemäß einem der Ansprüche 1 bis 2, **dadurch gekennzeichnet, daß** der Tank aus wenigstens einem ersten zylindrischen Tankmodul (4), das dazu ausgelegt ist, am ersten Einspritzmodul am ersten Ende der Einspritzleiste befestigt zu sein, und/oder einem zweiten zylindrischen Tankmodul, das dazu ausgelegt ist, an einem letzten Einspritzmodul an einem zweiten Ende der Einspritzleiste befestigt zu sein, gebildet ist.

5. Einspritzsystem gemäß einem der Ansprüche 1 bis 4, **dadurch gekennzeichnet, daß** das Material der Einspritzmodule (2a, 2b, 2c, 2d, 2e) eine der folgenden Materialarten ist: Aluminiumoxid (Al₂O₃), Graphitkohlenstoff, glasartiger Graphit, mit pyrolytischem Graphit ummantelter Kohlenstoff, gereinigter Kohlenstoff, mit Siliziumkarbid oder pyrolytischem Bornitrid ummantelter Kohlenstoff.

6. Einspritzsystem gemäß einem der Ansprüche 1 bis 5, das außerdem wenigstens eine zwischen zwei angrenzenden Einspritzmodulen (2a, 2b, 2c, 2d, 2e) und/oder zwischen dem Tankmodul (4) und dem ersten Einspritzmodul (2a) und/oder zwischen dem letzten Einspritzmodul (2e) und einem Verschlußmodul (6) angeordnete Kompressionsdichtung aufweist, wobei die wenigstens eine Wichtung dazu ausgelegt ist, die Ausrichtung der Düsen sicherzustellen, wenn sie komprimiert ist

7. Einspritzsystem gemäß einem der Ansprüche 1 bis 6, das außerdem jedem Einspritzmodul und/oder dem Tankmodul zugeordnete unabhängige Heizmittel (14) aufweist, wobei die Heizmittel (14) zwei halbzylindrische Halbschalen aufweisen, die dazu ausgelegt sind, das Einspritzmodul (2a, 2b, 2c, 2d, 2e) bzw. das Tankmodul (4) zu umhüllen.

8. Einspritzsystem gemäß Anspruch 7, bei dem die Halbschalen außerdem um die Heizmittel (14) herum angeordnete thermische Abschirmmittel (15) und um die thermischen Abschirmmittel (15) herum angeordnete Kühlmittel (16) aufweisen.

9. Einspritzsystem gemäß einem der Ansprüche 1 bis 8, das außerdem ein Chassis (11) und mechanische Mittel (13) zum Befestigen der Mehrzahl von Einspritzmodulen (2a, 2b, 2c, 2d, 2e) und/oder des Tankmoduls (4) auf dem Chassis (1) aufweist.

10. Einspritzsystem gemäß Anspruch 9, bei dem das Chassis eine oder mehrere gerade Stangen (11) aufweist, wobei die Befestigungsmittel so angebracht sind, daß sie entlang der Stange(n) (11) gleiten können.

11. Einspritzsystem gemäß einem der Ansprüche 1 bis 3, das eine Mehrzahl von Einspritzleisten aufweist, wobei die Längsachsen (5) der Einspritzleisten untereinander parallel angeordnet sind, um eine gleichmäßige gleichzeitige Verdampfung von Materialarten zu ermöglichen.

## Claims

1. An injection system for a device for depositing thin layers on a substrate (10) by vacuum evaporation, said injection system being intended to be placed in a vacuum evaporation chamber, and said injection system comprising:
- a container (4) for receiving a material to be evaporated,
- container heating means adapted to evaporate said material,
- at least one injection ramp (1) comprising an inner conduit connected to the container (4) so as to receive said evaporated material coming from the container (4) and a plurality of nozzles (3), each nozzle (3) comprising at least one communication channel between said inner conduit and the outer portion of the ramp, so as to diffuse the evaporated material into said vacuum evaporation chamber to enable diffusion of the evaporated material toward the substrate,
**characterized in that**:
- the injection ramp (1) comprises a plurality of injection modules (2a, 2b, 2c, 2d, 2e) mechanically connected to each other in series along a longitudinal direction (5), each injection module (2a, 2b, 2c, 2d, 2e) communicating via the inner conduit with one or at most two adjacent injection modules (2a, 2b, 2c, 2d, 2e), the container (4) being mechanically connected to a first injection module of said plurality of injection modules at a first end of the injection ramp, the first injection module communicating via the inner conduit with the container (4), each injection module (2a, 2b, 2c, 2d, 2e) comprising a plurality of injection nozzles (3), the injection nozzles being distributed with a constant interval between consecutive nozzles so as to obtain a spatially uniform distribution of the injection nozzles (3) along an axis parallel to the longitudinal direction, and
- said injection ramp (1) comprises means for adjusting in orientation said injection modules (2a, 2b, 2c, 2d, 2e) about said longitudinal direction (3) so as to align said injection nozzles (5) of said injection modules (2a, 2b, 2c, 2d, 2e) along a line parallel to the longitudinal direction (5) of the injection ramp (1) while ensuring tightness of fixation of said injection modules relatively to the vacuum evaporation chamber.

2. The injection system according to claim 1, wherein said injection modules (2a, 2b, 2c, 2d, 2e) are cylindrical in shape, the injection nozzles (3) of an injection module (2a, 2b, 2c, 2d, 2e) being arranged on a generating line of said cylinder.

3. The injection system according to claim 2, wherein said injection modules (2a, 2b, 2c, 2d, 2e) have an identical structure, the injection ramp further comprising a shutter module (6) adapted to tightly close an end of the injection ramp.

4. The injection system according to any one of claims 1 to 2, wherein said container is formed of at least one first cylindrical container module (4) adapted to be fixed on the first injection module at the first end of the injection ramp and/or of a second cylindrical container module adapted to be fixed on a last injection module at a second end of the injection ramp.

5. The injection system according to any one of claims 1 to 4, wherein the material of the injection modules (2a, 2b, 2c, 2d, 2e) is one of the following materials: alumina (Al₂O₃), graphitic carbon, glassy carbon, carbon coated with pyrolytic graphite, purified carbon, carbon coated with silicon carbide or pyrolytic boron nitride.

6. The injection system according to any one of claims 1 to 5, further comprising at least one compression sealing gasket arranged between two adjacent injection modules (2a, 2b, 2c, 2d, 2e) and/or between the container module (4) and the first injection module (2a) and/or between the last injection module (2e) and a shutter module (6), said at least one sealing gasket being adapted to ensure the alignment of the nozzles when compressed.

7. The injection system according to any one of claims 1 to 6, further comprising independent heating means (14) associated with each injection module and/or with the container module, said heating means (14) comprising two semi-cylindrical half-shells adapted to envelop said injection module (2a, 2b, 2c, 2d, 2e), respectively said container module (4).

8. The injection system according to claim 7, wherein the half-shells further comprise thermal shielding means (15) arranged about heating means (14) and cooling means (16) arranged about thermal shielding means (15).

9. The injection system according to any one of claims 1 to 8, further comprising a frame (11) and means (13) for the mechanical fixation of the plurality of injection modules (2a, 2b, 2c, 2d, 2e) and/or of the container module (4) to said frame.

10. The injection system according to claim 9, wherein said frame comprises one or several rectilinear bars (11), said fixation means being mounted so as to be able to slide along said bar(s) (11).

11. The injection system according to any one of claims 1 to 3 comprising a plurality of injection ramps, the longitudinal axes (5) of said injection ramps being arranged parallel to each other to allow a uniform coevaporation of the materials.
